# FASCICULE DE BREVET EUROPEEN

(11) **EP 0 605 303 B1**
(45) Date de publication et mention de la délivrance du brevet: **03.12.1997**
(21) Numéro de dépôt: 93403157.6
(22) Date de dépôt: 23.12.1993
(51) Int. Cl.: G01P 15/125

(54) **Accéléromètre intégré à axe sensible parallèle au substrat**
Integrierter Beschleunigungsmesser mit zum Substrat paralleler Messachse
Integrated accelerometer having the sensing axis parallel with the substrate

(30) Priorité: 28.12.1992 FR 9215770
(43) Date de publication de la demande: 06.07.1994
(73) Titulaire: COMMISSARIAT A L'ENERGIE ATOMIQUE, 75015 Paris Cédex 15 (FR)
(72) Inventeur: Diem, Bernard, F-38130 Echirolles (FR); Michel, France, F-38360 Sassenage (FR)
(74) Mandataire: Dubois-Chabert, Guy

(56) Documents cités:
- EP-A- 0 198 724
- WO-A-92/03740
- FR-A- 2 541 775
- US-A- 4 999 735

## Description

La présente invention a pour objet un accéléromètre intégré à axe sensible parallèle au substrat, destiné à mesurer l'accélération d'un corps mobile selon une direction parallèle au substrat.

L'accélération est aujourd'hui un paramètre qu'il est de plus en plus utile et nécessaire de connaître pour les besoins industriels, notamment dans le domaine spatial et aéronautique, et aussi pour des applications grand public comme l'automobile pour le contrôle de suspensions actives ou de ballons gonflables de sécurité (air-bag en terminologie anglo-saxonne).

Le développement de ces dernières utilisations nécessite une diminution très importante des coûts de fabrication, tout en conservant des qualités métrologiques acceptables des capteurs.

De nombreuses techniques ont été proposées pour réaliser des accéléromètres ou des structures mécaniques pour accéléromètres en silicium micro-usiné utilisant les technologies de la microélectronique.

L'avantage principal du silicium est évidemment le traitement collectif des structures et leur miniaturisation, donc un prix de revient relativement bas, mais aussi la fiabilité mécanique du matériau monocristallin ne présentant ni fluage, ni hystérésis, ni dérive dans le temps.

On distingue deux familles principales de capteurs d'accélération suivant la position de l'axe sensible par rapport au substrat semi-conducteur :
- les structures à axe sensible perpendiculaire au substrat qui sont les plus développées et qui utilisent les technologies conventionnelles d'usinage chimique anisotrope en volume du silicium ;
- les structures à axe sensible parallèle au substrat, dénommées ci-après "structure à axe parallèle", dont l'avantage principal est la possibilité d'intégrer sur le même substrat des accéléromètres sensibles à deux axes coplanaires, éventuellement perpendiculaires.

L'invention porte sur ce deuxième type de capteur.

Des capteurs à "axe parallèle" utilisant le silicium micro-usiné sont décrits dans la référence 1 - Transducers' 91 Digest of Technical papers, juin 1991, San Francisco, "A simple, high performance piezoresistive accelerometer" de J.T. Suminto, p.104-107 - et dans la référence 2 - US-A-4 653 326 déposé au nom du demandeur.

D'une manière générale, le principe de base mis en jeu dans les capteurs d'accélération en silicium est la mesure du déplacement ou de la force exercée par une masse sismique accrochée à un support par une ou plusieurs liaisons mécaniques souples, appelées poutre flexible.

Dans ces capteurs connus à "axe parallèle", la masse sismique et les poutres flexibles sont définies par usinage en volume d'un substrat en silicium, c'est-à-dire que toute l'épaisseur du substrat est gravée pour libérer les éléments mobiles (poutres et masse) de la structure.

Récemment, un capteur d'accélération avec son électronique intégrée a été commercialisé et fabriqué selon la technique d'usinage de surface en utilisant une couche sacrificielle d'oxyde et une couche déposée de silicium polycristallin, réalisant la structure mécanique désirée. Ce capteur est décrit dans la référence 3 - Electronic design, août 1991, p. 45-56, "Accelerometer's micromachined mass "moves" in plane of IC ; on-chip circuit controls it and senses G with force-balance techniques" de F. Goodenough - ou dans WO-A-92/03740.

Dans la référence 1, la mesure du déplacement de la masse sismique est assurée par des éléments piézorésistifs. Dans les références 2 et 3, les éventuels déplacements de la masse sismique sont déterminés par un système capacitif.

Les accéléromètres auxquels s'applique l'invention sont principalement ceux utilisant une détection capacitive mais ils peuvent aussi utiliser une détection piézorésistive.

Les accéléromètres à détection capacitive connus présentent l'inconvénient soit d'utiliser obligatoirement un substrat isolant, soit d'élaborer obligatoirement un croisement des conducteurs pour lier les électrodes aux contacts électriques impliquant une isolation difficile entre elles, et ce d'autant que ces électrodes sont portées à des potentiels différents. De plus, la réalisation de ces électrodes isolées est complexe.

Ces agencements sont destinés à éviter la présence de capacité parasite.

Par ailleurs, dans ces systèmes connus, la masse mobile est rendue conductrice soit par métallisation, comme décrit dans la référence 2, soit en utilisant du silicium conducteur. En outre, les cotés de la masse sismique s'étendant perpendiculairement au sens de déplacement de la masse sont disposés en regard de parties fixes conductrices et définissent avec celles-ci, de part et d'autre de la masse, des condensateurs de capacité variable.

La conductivité électrique des parties fixes peut être assurée soit par dépôt métallique comme dans la référence 2, soit en utilisant du silicium conducteur.

Dans la référence 3, l'accéléromètre comporte plusieurs condensateurs dont les contacts sont isolés électriquement et dont les armatures sont agencées selon les dents d'un peigne mobile disposé en regard de deux peignes fixes, de sorte qu'entre les armatures ou dents mobiles, solidaires de la masse mobile, est intercalée une armature ou dent de chaque peigne fixe.

Ici encore, l'isolation entre les électrodes croisées reste difficile à réaliser.

En outre, cet agencement particulier est destiné à empêcher la présence d'un condensateur parasite associée à chaque dent mobile.

L'accéléromètre de la référence 3 utilise comme poutre et masse mobiles du silicium polycristallin, ce qui entraîne, par rapport au silicium monocristallin, une diminution des qualités métrologiques du capteur ainsi que des problèmes de reproductibilité et de stabilité. De plus, ce capteur présente un rapport de forme des poutres peu avantageux en terme de directivité et donc une sensibilité importante aux accélérations transverses.

Ces inconvénients sont liés à l'emploi du silicium polycristallin dont l'épaisseur de dépôt n'excède pas quelques micromètres (inférieure à 2µm en général).

Une limitation de la directivité de la mesure ainsi que sur l'importance de la masse sismique conduit à une gamme de mesures restreinte.

L'invention a justement pour objet un nouvel accéléromètre intégré à axe sensible parallèle au substrat permettant de remédier à ces différents inconvénients. En particulier, cet accéléromètre ne présente pas de croisement de conducteurs liant les inconvénients. En particulier, cet accéléromètre ne présente pas de croisement de conducteurs liant les électrodes aux contacts électriques. En outre, il présente une directivité, une reproductibilité et une sensibilité plus élevées que celles des accéléromètres de l'art antérieur, tout en ne possédant pas de capacité parasite élevée.

A cet effet, l'invention a pour objet un accéléromètre intégré caractérisé en ce qu'il comporte un substrat conducteur ; une masse mobile liée mécaniquement, via un isolant, au substrat par au moins une poutre flexible et susceptible de se déplacer selon une première direction parallèle au substrat, la masse mobile comportant sur au moins un côté des dents mobiles conductrices reliées électriquement entre elles et orientées selon une seconde direction parallèle au substrat et perpendiculaire à la première direction ; des dents conductrices fixes reliées électriquement entre elles, solidaires et isolées du substrat, ces dents fixes étant orientées selon la seconde direction et alternant avec les dents mobiles pour former des condensateurs à capacité variable servant à mesurer les déplacements de la masse selon la première direction et/ou asservir ces déplacements ; au moins un écran électrostatique formé d'électrodes fixes en forme de doigts parallèles à la seconde direction, reliées électriquement entre elles et en contact direct avec le substrat, ces électrodes fixes étant disposées entre les dents fixes et les dents mobiles de sorte que chaque dent mobile soit intercalée entre une électrode fixe et une dent fixe.

En l'absence de cet écran électrostatique, une dent mobile constitue avec les deux dents fixes qui l'entourent deux condensateurs en parallèle dont la capacité varie en sens inverse. Pour une bonne détection de l'accélération il est nécessaire de supprimer l'effet de la variation de l'une de ces deux capacités.

Les doigts de l'écran électrostatique présents entre les dents fixes et les dents mobiles permettent d'annuler l'effet de variation de la capacité parasite et donc d'obtenir une fiabilité accrue du capteur, tout en assurant une simplification des moyens de traitement des signaux fournis par les moyens de mesure qui peuvent être capacitifs ou piézorésistifs. Dans ce dernier cas, les condensateurs à capacité variable ne servent qu'à l'asservissement des déplacements de la masse.

Afin d'assurer de bonnes qualités métrologiques, les dents mobiles, les dents fixes et les électrodes fixes sont réalisées en silicium monocristallin.

La conductivité des dents fixes et des dents mobiles peut être assurée soit par une métallisation des faces des dents en regard, soit en utilisant du silicium conducteur pour leur constitution. De préférence, on utilise du silicium conducteur.

Les électrodes jouant le rôle d'écran peuvent être réalisées en métal. Toutefois, pour des facilités de fabrication de l'accéléromètre, ces électrodes seront réalisées en silicium. Ainsi, l'ensemble des parties mobiles et des moyens de mesures peut être réalisé en une seule et même gravure d'un même matériau.

L'accéléromètre de l'invention peut être réalisé par gravure en volume d'un substrat de silicium monocristallin conducteur, ou mieux en utilisant une technologie de surface.

De préférence, on utilise une technologie de surface afin de réaliser le capteur de l'invention sur des substrats standards avec des machines standards, réduisant ainsi le coût du capteur.

D'autres caractéristiques et avantages de l'invention ressortiront mieux de la description qui va suivre, donnée à titre illustratif et non limitatif, en référence aux dessins annexés, dans lesquels :
- la figure 1 représente schématiquement en vue de dessus un accéléromètre à axe sensible parallèle au substrat, conforme à l'invention,
- la figure 2 est une vue en coupe selon la direction II-II de la figure 1, et
- la figure 3 est une vue en coupe selon la ligne III- III de la figure 1.

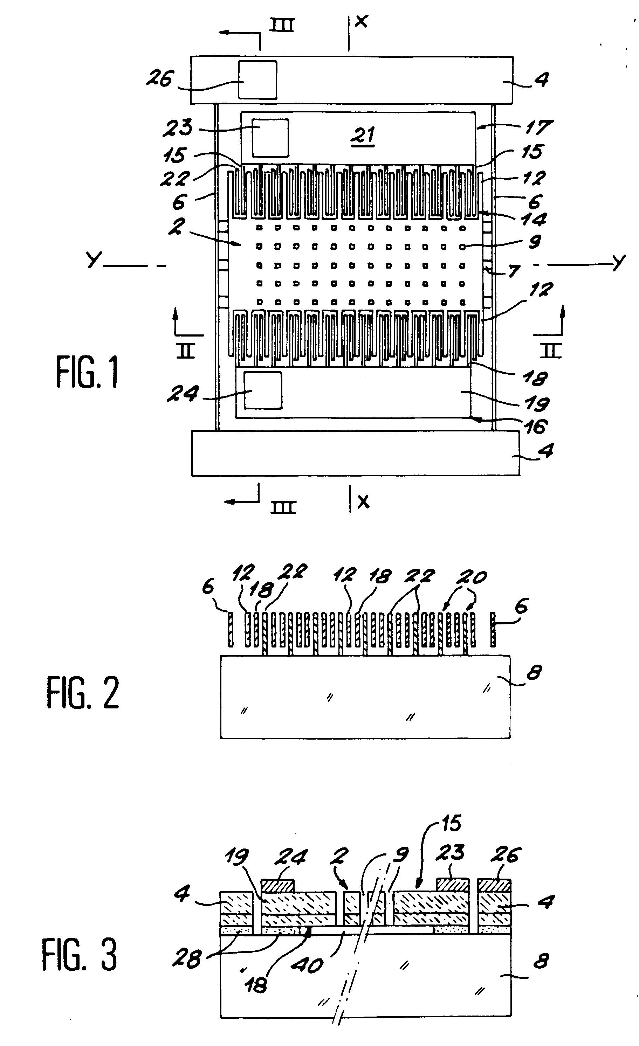

En référence aux figures 1 à 3, l'accéléromètre de l'invention comprend une masse sismique 2 mobile en silicium monocristallin dopé P par exemple, reliée par des poutres flexibles 6 à des éléments supports fixes 4. Cette masse 2 comporte des trous traversants 9 et des parties en saillie 7 assurant sa liaison avec les poutres.

Les éléments 4 sont solidaires mécaniquement et isolés électriquement d'un substrat 8.

Les éléments 4, les poutres 6 et le substrat 8 sont en silicium monocristallin de type P.

Sur la figure 1, l'accéléromètre comporte deux éléments supports 4 de part et d'autre de la masse sismique 2, reliés par deux poutres 6 orientées perpendiculairement aux éléments 4. Cette structure est donc symétrique par rapport à deux axes X et Y perpendiculaires, situés parallèlement à la surface du substrat 8.

Il est cependant possible de réaliser un accéléromètre ne comportant que le quart supérieur gauche de la structure, qui fonctionne aussi.

La masse sismique 2 de l'accéléromètre de la figure 1 comporte de part et d'autre de l'axe Y des électrodes 12 en forme de dents, orientées parallèlement à la direction X ; elles constituent deux premiers peignes 14 mobiles. En regard de chaque premier peigne 14 et décalé, on trouve un second peigne fixe respectivement 16 et 17 dont les dents 18 et 15 jouant le rôle d'électrodes sont parallèles à la direction X et encastrées entre les dents 12 du peigne 14. Ces peignes 16 et 17 sont aussi en silicium monocristallin dopé P et sont solidaires du substrat 8 par leur partie massive 19 et 21 (figure 3).

Selon l'invention, des électrodes fixes 22 en forme de doigt et jouant le rôle d'écran électrostatique sont intercalées entre les dents mobiles 12 et les dents fixes 18 ou 15. Ces électrodes fixes 22 sont aussi agencées en forme de peigne.

Du fait de la symétrie par rapport à l'axe Y, l'accéléromètre comporte deux écrans électrostatiques 20 disposés de part et d'autre de cet axe.

Chaque écran 20 est disposé de sorte que chaque dent mobile 12 soit intercalée entre une électrode fixe 22 et une dent fixe 18 ou 15.

Chaque écran électrostatique 20 est réalisé en silicium conducteur polycristallin ou monocristallin, dopé P de préférence et en même temps que la masse, les poutres 6 et les électrodes fixes 18 et 15.

Comme représenté sur la figure 2, les électrodes 22 fixes des écrans électrostatiques sont au contact direct du substrat 8 et donc reliées électriquement à ce dernier. En revanche, comme représenté sur la figure 3, les éléments supports 4 des poutres 6 et les parties massives 19 et 21 des peignes fixes 16 et 17 sont isolés électriquement du substrat 8 par une couche d'oxyde de silicium 28 gravée.

La masse sismique 2 est quant à elle suspendue au-dessus du substrat 8. La référence 40 indique l'espace vide séparant la masse sismique 2 du substrat 8.

L'agencement des électrodes ou dents 12 et 18 ou 15 et celui des écrans électrostatiques 20 permettent une mesure différentielle des déplacements de la masse 2 supportée par les poutres 6 selon la direction Y ainsi qu'un asservissement de la mesure.

Afin de mesurer les variations de capacité des condensateurs 12-18, un contact électrique 23 ou 24 de référence est prévu sur les peignes respectivement 17 ou 16. En outre, un contact électrique de mesure 26 est prévu sur l'un des éléments de support 4 afin d'assurer la mesure différentielle.

Sous l'effet d'une accélération selon la direction Y, la masse sismique 2 est soumise à une force (F=mγ) qui la fait se déplacer, suivant la raideur des poutres 6, d'une distance 1 parallèle à Y. Les capacités mesurées entre les électrodes 12 solidaires de la masse sismique 2 et les électrodes fixes 18 et 15 (qui servent de butées en cas de surcharge) des peignes 16, 17 et 14 "interdigités" vont varier de façon opposée.

L'interposition d'une électrode 22 d'un écran électrostatique 20 entre une face d'une électrode fixe 18 ou 15 et une face d'une électrode mobile 12 permet d'associer un seul condensateur de capacité variable à chaque dent mobile et donc d'annuler l'effet de la capacité parasite.

Electriquement, les trois séries d'électrodes 12, 18 ou 15, 22 sont isolées et sous l'effet d'un champ électrique E appliqué entre la masse sismique 2, via le contact 26, et une des deux électrodes 18 ou 15, respectivement via le contact 24 ou 23, une force électrostatique d'attraction est créée.

Pour un asservissement de la mesure, on utilise un dispositif de mesure connecté entre les contacts 24 ou 23 et 26 qui détecte la variation de capacité différentielle induite par le déplacement de la masse sismique selon Y lors d'une accélération. Ce dispositif du type capacimètre produit un signal de mesure alternatif de faible amplitude.

On superpose alors à celui-ci une polarisation continue appliquée, via les contacts 24 ou 23 et 26, entre les électrodes 12 et 18 ou 15 (qui voient leur capacité diminuer) permettant d'exercer une force (d'origine électrostatique) égale à celle créée par l'accélération selon Y et qui ramène la masse 2 à sa position d'équilibre et donc à la capacité initiale de chaque condensateur variable.

Cette polarisation est donc l'image de l'accélération selon Y et permet d'obtenir un capteur de très grande linéarité ainsi que de l'utiliser pour un autotest de la structure.

L'accéléromètre de l'invention peut être fabriqué en utilisant la technologie silicium/isolant et plus spécialement la technologie SIMOX qui consiste à implanter des ions oxygène dans le substrat monocristallin dopé P, à une dose de 10¹⁶ à 10¹⁸ions/cm², puis à recuire la structure implantée à une température allant de 1150°C à 1400°C. On obtient ainsi un film de silicium monocristallin isolé du substrat 8 par une couche d'oxyde 28.

On forme alors, par les procédés classiques de photolithographie les poutres, la masse mobile et ses électrodes mobiles ainsi que les électrodes fixes par gravure du silicium surmontant la couche d'oxyde, puis les écrans électrostatiques 20 dans une couche épitaxiée de silicium. On élimine ensuite l'oxyde 28 sous la masse sismique via les trous 9 et les bords par attaque chimique en utilisant de l'acide fluorhydrique.

La densité des trous permet une gravure de la couche enterrée de SiO₂ plus ou moins rapide sans attaque importante des supports de structure 4 et 17 et 19.

## Revendications

1. Accéléromètre intégré, caractérisé en ce qu'il comporte un substrat conducteur (8), une masse mobile (2) liée mécaniquement, via un isolant (28), au substrat par au moins une poutre flexible (6) et susceptible de se déplacer selon une première direction (Y) parallèle au substrat, la masse mobile comportant sur au moins un côté des dents mobiles conductrices (12) reliées électriquement entre elles et orientées selon une seconde direction (X) parallèle au substrat (8) et perpendiculaire à la première direction (Y) ; des dents conductrices fixes (18, 15) reliées électriquement entre elles, solidaires et isolées du substrat, ces dents fixes étant orientées selon la seconde direction (X) et alternant avec les dents mobiles pour former des condensateurs à capacité variable servant à mesurer les déplacements de la masse selon la première direction et/ou à asservir ces déplacements ; au moins un écran électrostatique (20) formé d'électrodes fixes (22) en forme de doigts parallèles à la seconde direction (X), reliées électriquement entre elles et en contact direct avec le substrat, ces électrodes fixes étant disposées entre les dents fixes (18, 15) et les dents mobiles (12) de sorte que chaque dent mobile soit intercalée entre une électrode fixe et une dent fixe.

2. Accéléromètre selon la revendication 1, la masse mobile comportant deux séries de dents mobiles (12) conductrices disposées selon deux cotés opposés parallèles à la première direction et associées chacune à une série de dents fixes (18, 15) conductrices et à un écran électrostatique (20).

3. Accéléromètre selon la revendication 1 ou 2, la masse étant reliée mécaniquement au substrat par deux poutres flexibles (6).

4. Accéléromètre selon l'une quelconque des revendications 1 à 3, la masse mobile (2) pourvue de ses dents mobiles (12), les dents fixes (18, 15), le ou les écrans électrostatiques (20) étant réalisés en silicium monocristallin électriquement conducteur.

5. Accéléromètre selon l'une quelconque des revendications 1 à 4, les poutres étant conductrices et un isolant électrique (28) étant interposé entre la ou les poutres (6) et le substrat (8).

6. Accéléromètre selon l'une quelconque des revendications 1 à 5, le substrat étant en silicium monocristallin dopé.

7. Accéléromètre selon l'une quelconque des revendications 1 à 6, la masse sismique comportant des trous (9) traversants.

## Patentansprüche

1. Integrierter Beschleunigungsmesser,
**dadurch gekennzeichnet,** daß er umfaßt: ein leitendes Substrat (8) und eine bewegliche Masse (2), mit dem Substrat über einen Isolator (28) mechanisch verbunden durch wenigstens einen flexiblen Träger (6) und in einer ersten Richtung (Y) verschiebbar, parallel zum Substrat, wobei die bewegliche Masse auf wenigstens einer Seite bewegliche leitende Zähne (12) aufweist, elektrisch miteinander verbunden und ausgerichtet entsprechend einer zum Substrat parallelen und zu der ersten Richtung (Y) senkrechten zweiten Richtung (X); feststehende leitende Zähne (18, 15), elektrisch miteinander verbunden, fest mit dem Substrat verbunden und von diesem isoliert, wobei diese feststehenden Zähne nach der zweiten Richtung (X) ausgerichtet sind und mit den beweglichen Zähnen abwechseln, um Kondensatoren mit variabler Kapazität zu bilden, die dazu dienen, die Verschiebungen der Masse in der ersten Richtung zu messen und/oder diese Verschiebungen zu steuern; wenigstens eine elektrostatische Abschirmung (20), gebildet durch feststehende Elektroden (22) in Form von parallelen Fingern mit der zweiten Richtung (X), elektrisch miteinander verbunden und in direktem Kontakt mit dem Substrat, wobei diese feststehenden Elektroden zwischen den feststehenden Zähnen (18. 15) angeordnet sind und die beweglichen Zähne (12) derart, daß jeder bewegliche Zahn eingefügt ist zwischen eine feststehende Elektrode und einen feststehenden Zahn.

2. Beschleunigungsmesser nach Anspruch 1, wobei die bewegliche Masse zwei Serien bzw. Reihen beweglicher leitender Zähne (12) umfaßt, angeordnet längs zwei entgegengesetzten, zu der ersten Richtung parallelen Seiten, und jede einer Reihe feststehender leitender Zähne (18, 15) und einer elektrostatischen Abschirmung (20) zugeordnet.

3. Beschleunigungsmesser nach Anspruch 1 oder 2, wobei die Masse mechanisch mit dem Substrat durch zwei flexible Träger (6) verbunden ist.

4. Beschleunigungsmesser nach einem der Ansprüche 1 bis 3, wobei die bewegliche Masse (2) mit ihren beweglichen Zähnen (12), die feststehenden Zähne (15, 18) und die elektrostatische(n) Abschirmung(en) (20) aus elektrisch leitendem monokristallinem Silicium hergestellt sind.

5. Beschleunigungsmesser nach einem der Ansprüche 1 bis 4, wobei die Träger leitend sind und ein elektrischer Isolator (28) zwischen den oder die Träger und das Substrat eingefügt ist.

6. Beschleunigungsmesser nach einem der Ansprüche 1 bis 5, wobei das Substrat aus dotiertem monokristallinem Silicium ist.

7. Beschleunigungsmesser nach einem der Ansprüche 1 bis 6, wobei die seismische Masse Durchgangslöcher (9) aufweist.

## Claims

1. Integrated accelerometer, characterized in that it comprises a conductive substrate (8) a mobile mass (2) mechanically connected, via an insulator (28), to the substrate by at least one flexible beam (6) and able to move in a first direction (Y) parallel to the substrate, the mobile mass having on at least one side conductive mobile teeth (12) which are electrically interconnected and oriented in a second direction (X) parallel to the substrate (8) and perpendicular to the first direction (Y), fixed conductive teeth (18, 15) which are electrically interconnected, integral and insulated with respect to the substrate, said fixed teeth being oriented in the second direction (X) and alternate with the mobile teeth in order to form variable capacitance capacitors for measuring the displacement of the mass in the first direction and/or servocontrolling said displacements, at least one electrostatic screen (20) formed from finger-like fixed electrodes (22) parallel to the second direction (X) and which are electrically interconnected, said fixed electrodes being placed between the fixed teeth (18, 15) and the mobile teeth (12) in such a way that each mobile tooth is intercalated between a fixed electrode and a fixed tooth.

2. Accelerometer according to claim 1, the mobile mass having two series of mobile conductive teeth (12) arranged along two opposite sides parallel to the first direction and each associated with a series of fixed conductive teeth (18, 15) and an electrostatic screen (20).

3. Accelerometer according to claim 1 ot 2, the mass being mechanically connected to the substrate by two flexible beams (6).

4. Accelerometer according to any one of the claims 1 to 3, the mobile mass (2) provided with its mobile teeth (12), the fixed teeth (18, 15) as well as the electrostatic screen or screens (20) being made from electrically conductive monocrystalline silicon.

5. Accelerometer according to any one of the claims 1 to 4, where the beams are conductive and where an electrical insulator (28) is placed between the beam or beams (6) and the substrate (8).

6. Accelerometer according to any one of the claims 1 to 5, the substrate being of doped monocrystalline silicon.

7. Accelerometer according to any one of the claims 1 to 6, the seismic mass having through holes (9).
